# EUROPEAN PATENT APPLICATION

(11) **EP 4 203 023 A1**
(43) Date of publication of application: **28.06.2023**
(21) Application number: 22214306.7
(22) Date of filing: 16.12.2022
(51) Int. Cl.: H01L 23/498, H01L 23/48, H01L 23/538

(54) **CONDUCTIVE FEATURES FORMED USING METAL ASSISTED ETCH**

(30) Priority: 20.12.2021 US 202117556520
(71) Applicant: INTEL Corporation, Santa Clara, CA 95054 (US)
(72) Inventor: MAJHI, Prashant, San Jose, 95121 (US); MURTHY, Anand, Portland, 97229 (US)
(74) Representative: 2SPL Patentanwälte PartG mbB

(57) **Abstract**

An apparatus includes a first layer comprising silicon, and a conductive feature extending within the silicon of the first layer. The conductive feature includes (i) conductive material extending throughout the length of the conductive feature, (ii) a barrier layer between the conductive material and the silicon of the first layer, and (iii) a second layer including dielectric material between the barrier layer and the silicon of the first layer. In an example, one or more discontinuous monolayers of metal are between sections of the dielectric material and the silicon of the first layer. The conductive feature is formed in a recess extending within the silicon of the first layer. In an example, the recess is formed using a metal assisted etch process using the metal as a catalyst, and one or more discontinuous monolayers of the metal are remnants of the metal used in the metal assisted etch process.

## Description

### BACKGROUND

Fabrication of microelectronic devices involves forming electronic components on microelectronic substrates, such as silicon wafers. Conductive vias extending through dielectric or semiconductor material are often used in many such microelectronic devices. For example, conductive vias (e.g., through-silicon vias or TSVs) may be present in interposer structures, where such an interposer structure may be used, merely as an example, in a three-dimensional (3D) System on a Chip (SoC) system, to interconnect two or more stacked integrated circuit (IC) chips. In another example, deep trench conductive vias may be used in capacitors. However, non-trivial issues remain with respect to forming such conductive vias.

### BRIEF DESCRIPTION OF THE DRAWINGS

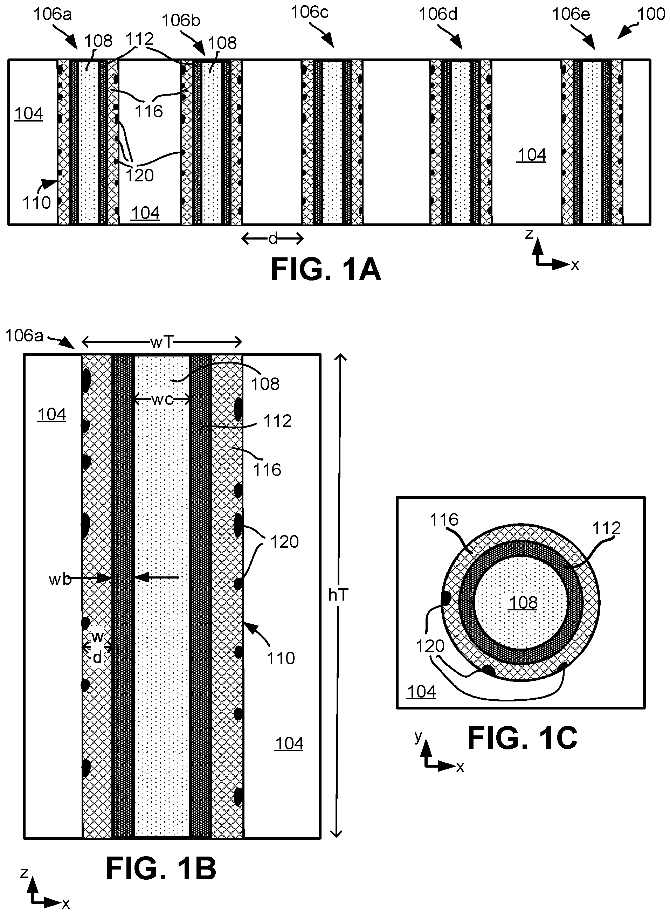

Fig. 1A illustrates a cross-sectional view of an interposer structure including (i) a layer comprising semiconductor material such as silicon, and (ii) a plurality of conductive features extending through the semiconductor material of the layer, wherein a recess for a conductive feature is formed using metal assisted etch, and trace amount of the metal (e.g., one or more discontinuous monolayers of the metal) used for the metal assisted etch process is present between the conductive feature and the semiconductor material of the layer, in accordance with an embodiment of the present disclosure.
Fig. 1B illustrates a magnified cross-sectional view of a conductive feature of the interposer structure of Fig. 1A, in accordance with an embodiment of the present disclosure.
Fig. 1C illustrates a plan view of a conductive feature of the interposer structure of Fig. 1A, in accordance with an embodiment of the present disclosure.
Fig. 1D illustrates an example system in which the interposer structure of Figs. 1A-1C may be used, in accordance with an embodiment of the present disclosure.
Fig. 2 illustrates a flowchart depicting a method of forming an interposer structure including (i) a layer comprising semiconductor material such as silicon, and (ii) a plurality of conductive features extending through the semiconductor material of the layer, wherein a recess for a conductive feature is formed using metal assisted etch, and trace amount of the metal used for the metal assisted etch process is present between the conductive feature and the semiconductor material of the layer, in accordance with an embodiment of the present disclosure.
Figs. 3A, 3B, 3C, 3D, 3E, 3F, 3G, 3H, and 31 illustrate cross-sectional views of at least a section of the interposer structure of Figs. 1A-2 in various stages of processing, in accordance with an embodiment of the present disclosure.
Fig. 4 illustrates a cross-sectional view of a capacitor structure including (i) a layer comprising doped semiconductor material such as doped silicon, and (ii) a plurality of conductive features extending within the doped semiconductor material of the layer, and trace amount of metal (e.g., one or more discontinuous monolayers of the metal) between each of the conductive features and the doped semiconductor material of the layer, in accordance with an embodiment of the present disclosure.
Fig. 5 illustrates a cross-sectional view of an integrated circuit structure including a heat spreader that comprises (i) a plurality of recesses formed using a metal assisted etch process, such that trace amount of metal (e.g., one or more discontinuous monolayers of the metal) are on walls of the recesses, and (ii) fluid within the recesses to dissipate heat from the IC structure, in accordance with an embodiment of the present disclosure.
Fig. 6 illustrates a computing system having conductive features and/or recesses formed using the techniques disclosed herein, in accordance with some embodiments of the present disclosure.

These and other features of the present embodiments will be understood better by reading the following detailed description, taken together with the figures herein described. In the drawings, each identical or nearly identical component that is illustrated in various figures may be represented by a like numeral. For purposes of clarity, not every component may be labeled in every drawing. Furthermore, as will be appreciated, the figures are not necessarily drawn to scale or intended to limit the described embodiments to the specific configurations shown. For instance, while some figures generally indicate straight lines, right angles, and smooth surfaces, an actual implementation of the disclosed techniques may have less than perfect straight lines and right angles (e.g., curved or tapered sidewalls and round corners), and some features may have surface topography or otherwise be non-smooth, given real-world limitations of fabrication processes. Further still, some of the features in the drawings may include a patterned and/or shaded fill, which is merely provided to assist in visually identifying the different features. In short, the figures are provided merely to show example structures.

### DETAILED DESCRIPTION

Microelectronic device structures including conductive vias formed using metal assisted etching process are provided herein. In one embodiment, an apparatus includes a first layer comprising silicon, and a conductive feature extending within the silicon of the first layer. In an example, the conductive feature includes (i) conductive material extending throughout the length of the conductive feature, (ii) a barrier layer between the conductive material and the silicon of the first layer, and (iii) a second layer including dielectric material between the barrier layer and the silicon of the first layer. In an example, one or more monolayers of metal are between sections of the dielectric material and the silicon of the first layer. In an example, the one or more monolayers of metal are discontinuous, such that the one or more monolayers are between some sections of the dielectric material and the silicon of the first layer, and not between other sections of the dielectric material and the silicon of the first layer. The conductive feature is formed in a recess extending within the silicon of the first layer. In an example, the recess is formed using a metal assisted etching process using the metal as a catalyst, and one or more monolayers of the metal are remnants of the metal used to etch the recess within the silicon of the layer using the metal assisted etch process.

In another embodiment, a microelectronics device comprises a layer comprising semiconductor material, a recess extending within the semiconductor material of the layer, and trace amount of a metal on walls of the recess. In an example, the trace amount of metal has a concentration of at most 1000 parts per million (ppm). In an example, the microelectronics device further comprises a dielectric material at least in part on walls of the recess. In an example, the trace amount of metal is between some sections of the dielectric material and the walls of the recess, and not between other sections of the dielectric material and the walls of the recess. The microelectronics device further comprises conductive material within the recess.

In a further embodiment, an integrated circuit device comprises a layer comprising semiconductor material, a plurality of active devices below the layer comprising the semiconductor material, and a plurality of recesses extending within the semiconductor material of the layer. In an example, a top end of each of the plurality of recesses is exposed through a top surface of the layer. In an example, one or more monolayers of metal may be on walls of each recess of the plurality of recesses. The one or more monolayers may be discontinuous as noted above. The integrated circuit device further comprises a fluid within one or more recesses of the plurality of recesses.

In yet another embodiment, a method of forming a conductive feature within a layer comprising semiconductor material comprises depositing (i) a metal on a first section of a top surface of the layer, and (ii) one or more masks on one or more second sections of the top surface of the layer. The method further comprises etching a portion of the layer underneath the first section using a metal assisted etch process, to define a recess within the layer. In an example, the metal acts as a catalyst in the etching process. The method further comprises removing the metal from the recess. In an example, remnants of the metal (e.g., trace amount of the metal) may remain on sidewalls of the recess, even after the metal removal process. The method further comprises depositing dielectric material at least in part on sidewalls of the recess. In an example, the remnants of the metal may be between some sections of the dielectric material and the sidewalls of the recess, and not between other sections of the dielectric material and the sidewalls of the recess. The method further comprises depositing conductive material within the recess.

Numerous variations, embodiments, and applications will be apparent in light of the present disclosure.

### General Overview

As previously noted, non-trivial issues remain with respect to forming conductive vias through semiconductor material. For example, a reactive ion etch (RIE) process is generally employed to form recesses for conductive vias. However, RIE process may have significant financial cost associated with it, for example, due to patterning of relatively thick hard mask and subsequent semiconductor material etch. In another example, an RIE process can generate recesses that have to spaced sufficiently apart from each other, e.g., due to keep out zone limitations, and may not be able to generate relatively high aspect ratio vias.

Accordingly, techniques are provided herein to form conductive vias and trenches using a metal assisted etch process. Metal assisted etch, also known as metal induced etch (MIE) or metal assisted chemical etching (MACE), is the process of wet chemical etching of semiconductor material (e.g., silicon or other suitable semiconductor material) with the use of a metal catalyst, usually deposited on the surface of the semiconductor material in the form of a thin film or nanoparticles. The semiconductor material, with the metal deposited thereon, is then immersed in an etching solution containing an appropriate oxidizing agent and hydrofluoric acid. The metal on the surface catalyzes the reduction of the oxidizing agent and therefore, in turn, facilitates dissolution of the semiconductor material. This leads to formation of straight recesses or trenches that are etched into the semiconductor material. Thus, a pre-defined pattern of the metal on the surface of the semiconductor material can be directly transferred to the semiconductor material in the form of corresponding recesses.

In an example, walls of a recess formed using the metal assisted etch process may be lined with dielectric material and a barrier layer, then filed with conductive material, to form a conductive feature, such as a conductive via. The dielectric material, in an example, prevents or reduces electrical interaction between the conductive material and the adjacent semiconductor material. In an example, the conductive material within the recess tends to diffuse through the adjacent dielectric material. In an example where the conductive material is copper, the diffusion may result in formation of undesirable copper oxide. The barrier layer separates the conductive material from the dielectric material, and in an example, prevents diffusion of the conductive material (such as copper) to the dielectric material. Furthermore, the barrier layer facilitates better adhesion of the conductive material on walls of the recess.

In an example, the semiconductor material, within which the above discussed recess and the conductive feature therewithin are formed, can be any appropriate semiconductor material within which recesses may be formed using the metal assisted etching process. In an example, the semiconductor material comprises silicon. In such a case, the conductive feature may be a through-silicon via (TSV), for example.

In an example, subsequent to the metal assisted etching process (and prior to deposition of dielectric material and conductive material), the metal used as a catalyst is removed from the resultant recess. However, due to unintended limitations in the metal removal process, remnants of the metal may remain on walls of the recesses. Thus, after deposition of the dielectric material of the conductive feature within the recess, remnants of the metal are between some sections of the dielectric material within the recess and the semiconductor material within which the recess is formed, while the remnants of the metal may be absent between other sections of the dielectric material and the semiconductor material within which the recess is formed. In an example, the remnants of the metal form one or more discontinuous monolayers of metal on walls of the recess. The remnants of the metal are present in trace amount within the recess, e.g., in parts per million (ppm) range or even in parts per billion (ppb) range. An amount of remnants of the metal present in a recess depends on thoroughness of a cleaning process to remove the metal catalyst after the metal assisted etching process.

In an example, the conductive feature may be formed within semiconductor material of an interposer structure. For example, the conductive feature, which may be a conductive via, may extend through the interposer, such that a top end of the conductive feature is exposed through a top surface of the interposer, and a bottom end of the conductive feature is exposed through a bottom surface of the interposer. Solder bumps may be attached to the top and bottom ends of the conductive feature, to attach the interposer to external components (such as an IC chip, a package substrate, and/or a printed circuit board). In an example, the interposer structure couples one or more IC chips (some of which may be relatively smaller IC chip, such as chiplets) to other microelectronics device structures such as a package substrate or a printed circuit board.

In an example, the conductive feature may also be used to form a capacitor, such as a metal-insulator-silicon (MIS) capacitor. For example, a plurality of such conductive features may be formed within appropriate doped silicon, using the above discussed metal assisted etching process. A conductive line is coupled to top ends of each of the plurality of conductive features. In an example, the conductive line forms a first terminal of the capacitor. A second terminal of the capacitor may be buried within the doped silicon. The conductive features and the doped silicon, in combination, form the metal-insulator-silicon capacitor, in an example. Note that the trace amounts of remnant metal are present between the conductive features and the doped silicon, e.g., on walls of the recesses within which the conductive features are formed.

In an example, the vias or trenches formed using the metal assisted etching process can also be used for various other applications. For example, the resultant recesses can be used to form fins of a heat spreader. In such an example, the recesses are formed in close proximity to each other using the metal assisted etch process, such that the material between two adjacent recesses form a fin of the heat spreader. The recesses are filed with cooling fluid, such as an immersion liquid used to cool an IC structure attached to the heat spreader. Note that the trace amount of metal from the metal assisted process can be present on walls of the recesses of the heat spreader.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. In particular, in some embodiments, such tools may be used to detect a conductive feature comprising conductive material, dielectric material, and a barrier layer between the conductive material and the dielectric material, wherein the conductive feature is in a recess that is formed within a semiconductor material using a metal assisted etching process. In some embodiments, such tools may be used to further detect trace amounts of remnants of the metal on walls of the recess (e.g., between the semiconductor material and the dielectric material).

Numerous configurations and variations will be apparent in light of this disclosure.

### Architecture and Methodology

Fig. 1A illustrates a cross-sectional view of an interposer structure 100 including (i) a layer 104 comprising semiconductor material such as silicon, and (ii) a plurality of conductive features 106 extending within (e.g., extending through) the semiconductor material of the layer 104, wherein a via or recess 110 for a conductive feature 106 is formed using metal assisted etch with metal as a catalyst, and trace amount of the metal 120 (e.g., one or more discontinuous monolayers of the metal) used for the metal assisted etch process is present between the conductive feature 106 and the semiconductor material of the layer 104, in accordance with an embodiment of the present disclosure. Fig. 1B illustrates a magnified cross-sectional view of a conductive feature 106 of the interposer structure 100 of Fig. 1A, and Fig. 1C illustrates a plan or top view of a conductive feature 106 of the interposer structure 100 of Fig. 1A, in accordance with an embodiment of the present disclosure. Fig. 1A illustrates five example conductive features 106a, 106b, 106c, 106d, 106e, although the interposer structure 100 may comprise any other appropriate number of such conductive features 106.

In one embodiment, the layer 104 comprises any appropriate semiconductor material (or another appropriate type of dielectric or insulator material) through which a recess can be formed using a metal assisted etching process. For example, the layer 104 comprises such as silicon. In an example, the layer 104 comprises bulk silicon. The silicon of the layer 104 may comprise some impurity and may be appropriately doped in an example. In another example and as discussed with respect to Figs. 1A-1B, the silicon of the layer 104 may be undoped.

A specific conductive feature 106a is discussed in further detail with respect to Fig. 1B, and the other conductive features may have a structure similar to that of the conductive feature 106a of Fig. 1B. In an example, the conductive feature 106a (also referred to herein specifically as feature 106a, and generally as feature 106) comprises conductive material 108 extending through a length of the feature 106. Thus, in the example of Figs. 1A and 1B, the conductive material 108 extends from a top surface of the layer 104 to a bottom surface of the layer 104.

In one embodiment, the conductive material 108 comprises copper having relatively low resistance. In another embodiment, the conductive material 108 comprises one or more of copper, ruthenium, molybdenum, or tungsten. The plan view of Fig. 1C illustrates the conductive material 108 to have a circular cross section, although the conductive material 108 may have a square cross section, a rectangular cross section, or another appropriate cross-sectional shape.

In one embodiment, a barrier layer 112 separates the conductive material 108 from the semiconductor material of the layer 104. For example, the barrier layer 112 is on an outer periphery or outer surface of the conductive feature 106a. Although the layer 112 is termed herein as a "barrier layer," the layer 112 may act as a barrier layer or a liner layer. For example, conductive material 108 within the feature 106 may tend to diffuse through adjacent dielectric material 116. In an example where the conductive material is copper, the diffusion may result in formation of undesirable copper oxide. The barrier (or linear) layer 112, in an example, prevents diffusion of the conductive material 108 (such as copper) to dielectric material 116 adjacent to the conductive material 108. Furthermore, the barrier layer 112 facilitates better adhesion of the conductive material 108 on walls of the dielectric layer 116.

Thus, in an example where the conductive material 108 is copper, the barrier layer 112 is present in the feature 106, to prevent diffusion of copper through adjacent dielectric material 116 and formation of undesirable copper oxide. However, in another example where other type of conductive material 108 is used (such as ruthenium) that typically does not diffuse or form respective oxides, the barrier layer 112 may be absent or may be replaced with a linear layer.

In an example, the barrier layer 112 has a thickness or width wb in the range of 1 to 5 nanometers (nm), or 1 to 10 nm, or 0.5 to 10 nm, or 1 to 20 nm, or 3 to 20 nm, although other appropriate range is also possible. The width wb is measured in a horizontal direction, which is perpendicular to a length of the feature 106.

Suitable materials for the barrier layer 112 include barrier layer refractory metals and alloys, cobalt, cobalt-nickel (CoNi), ruthenium-cobalt combination, molybdenum, nickel, manganese, titanium-tungsten (TiW), tantalum (Ta), tantalum-nitride (TaN), tantalum-silicon-nitride (TaSiN), titanium-nitride (TiN), titanium-silicon-nitride (TiSiN), tungsten-nitride (WN), tungsten-silicon-nitride (WiSiN), and/or combinations of such materials (e.g., a multi-lay stack of Ta/TaN).

In one embodiment, a layer 116 comprising dielectric material (or insulator material) separates the conductive material 108 and the barrier layer 112 from the semiconductor material of the layer 104. For example, the dielectric material layer 116 is on an outer periphery or outer surface of the barrier layer 112. The dielectric material layer 116 may comprise any appropriate dielectric material or insulator material, such as an appropriate oxide (such as silicon oxide) or nitride (such as silicon nitride). The dielectric material layer 116, in an example, prevents or reduces electrical interaction between the conductive material 108 and the semiconductor material of the layer 104.

As illustrated in Fig. 1B, the dielectric material layer 116 has a thickness or width wd measured in a horizontal direction, which is perpendicular to a length of the feature 106. The width wd may be based on a voltage of signals conducted by the features 106. For example, relatively higher voltage signals may necessitate a relatively higher width wd, to prevent electrical interaction between the conductive material 108 and the semiconductor material of the layer 104. The dielectric material layer 116 may have a thickness or width wd in the range of 5 to 200 nm, although other thickness range is also possible.

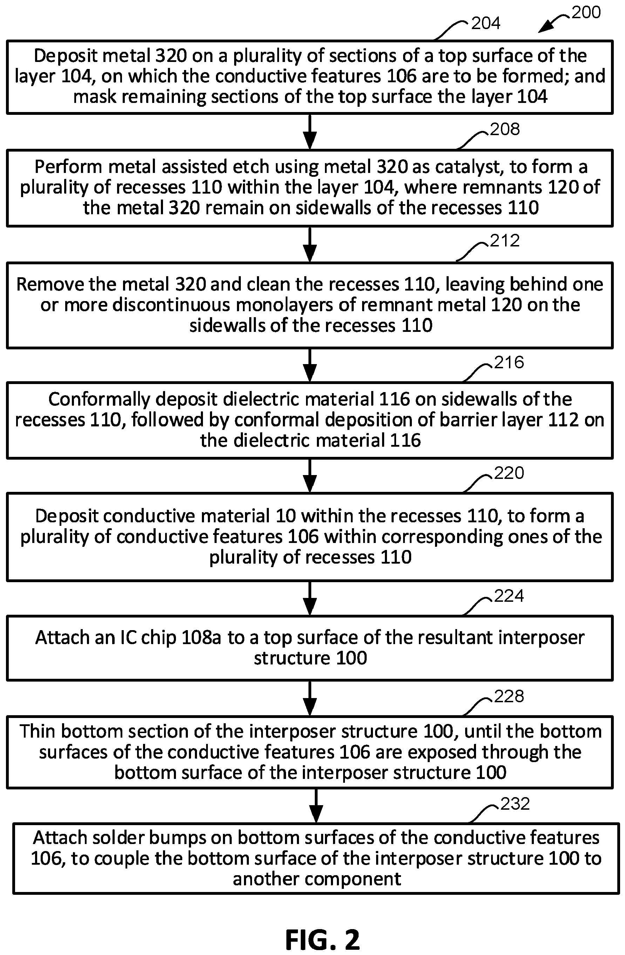

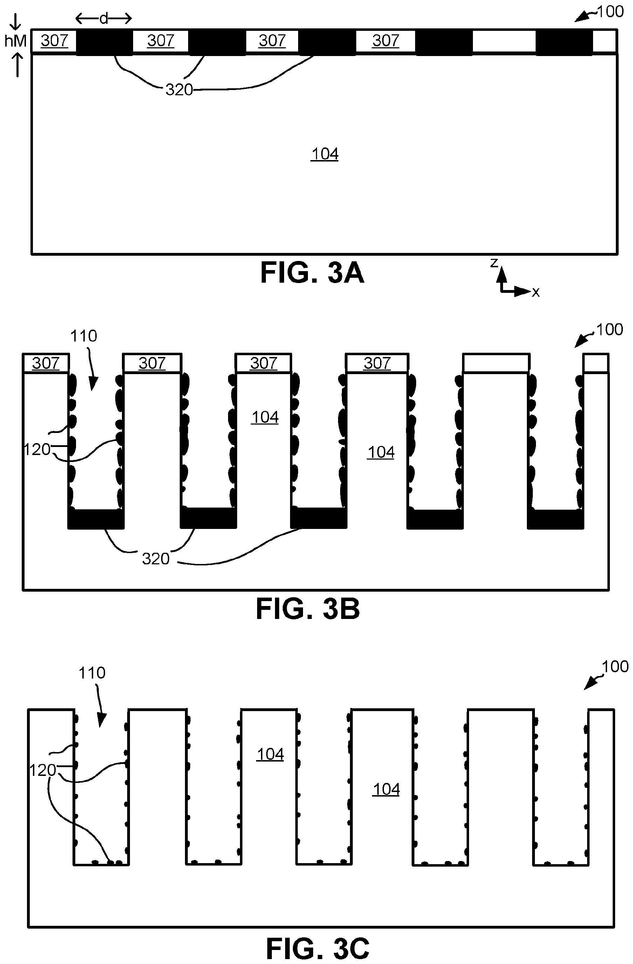

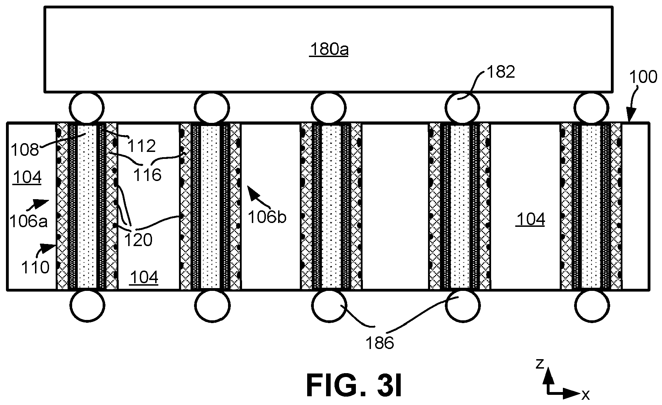

As will be discussed herein in further detail in turn (e.g., see Figs. 2 and 3A-3C), the recess 110 for the feature 106 is formed using a metal assisted etch process. In one embodiment, trace amount of the metal 120 used for the etch process may be present on walls of the recess 110. For example, one or more monolayers of the metal 120 may be present on sidewalls of the recess 110. The monolayers of the metal 120 may be discontinuous, such that the monolayers are between some sections of the dielectric material 116 and the semiconductor material of the layer 104, and not between other sections of the dielectric material 116 and the semiconductor material of the layer 104. Thus, Figs. 1A and 1B illustrate fragments or remnants of the metal 120 on the sidewalls of the recess 110. Note that the trace amount of the metal 120 does not have a functional role in the interposer structure 120, and are merely remnants of the metal 120 that are left behind during the metal removal and cleaning process.

Note that the figures are not drawn to the scale, and the trace amount of metal 120 are magnified in the illustration of Figs. 1A and 1B relative to various other components.

In an example, the choice of metal 120 depends on an etch chemistry used for the metal assisted etching process. Examples of the metal 120 may include gold, silver, platinum, palladium, nickel, and/or another appropriate metal that can be used for a metal assisted etch process.

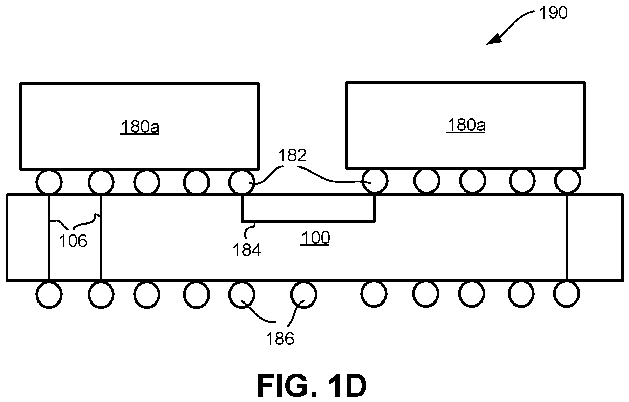

As discussed, the structure 100 acts as an interposer, e.g., to couple an IC chip (which may, in an example, be an IC chiplet) to other microelectronics device structures, an example of which is illustrated in Fig. 1D herein later in turn. In an example, the interposer structure 100 may not have any active devices such as transistors. In another example, the interposer structure 100 may have one or more active devices (such as transistors, although not illustrated in Figs. 1A, 1B) present. However, even if such active devices are present within the structure 100, such active devices may be located within the structure 100 at a location that is relatively far from the features 106. Merely as an example, the features 106 may be present at or near a periphery of the structure 100, whereas the active devices, if present, may be at or near a central section of the structure 100. Thus, put differently, no active devices may be present within immediate vicinity (e.g., within 100 microns, or 200 microns, or 500 microns) of any of the features 106. Hence, even if the remnant metal 120 diffuse through the semiconductor material of the layer 104 and contaminate the semiconductor material of the layer 104 within immediate vicinity of the feature 106, such diffusion and contamination may not affect any nearby active devices, e.g., as active devices may not be present within the immediate vicinity of the features 106. Thus, in an example, the remnant metal 120 present in trace amount may not be a cause of concern and may not adversely affect functionality or performance of the structure 100.

An amount of the remnant metal 120 present in the structure 100 may be based on a removal and cleaning process used to remove the remnant metal 120, e.g., after the recess 110 has been formed, as discussed with respect to Figs. 2 and 3B-3C. For example, if metal contamination is a concern (as discussed herein above, where the remnant metal 120 may possibly diffuse and contaminate adjacent silicon of the layer 104), an enhanced removal and cleaning process of the metal 120 after formation of the recess 110 may be undertaken, resulting is relatively less amount of the remnant metal 120 being present within the recess 110. However, if metal contamination is not a concern (e.g., because of lack of active devices in immediate vicinity of the features 106), a regular removal and cleaning process may be undertaken, resulting is relatively higher amount of the remnant metal 120 being present within the recess 110. In an example, about 0.05% to 1% of the total metal 320 (see Figs. 3A and 3B) used for the metal assisted etching process remains as remnant metal 120 within the recess 120, after the removal and cleaning process of the metal 320 subsequent to formation of the recess 110.

In an example, the remnant metal 120 may be present in trace amount, such as in parts per million (ppm) range, or parts per billion (ppb) range. Merely as an example, the remnant metal 120 present in the structure 100 may be at most 2000 ppm, at most 1000 ppm, or at most 500 ppm, or at most 100 ppm, or at most 10 ppm, or at most 1 ppm, e.g., depending on the extent of the removal and cleaning process of the metal subsequent to formation of the recess 110 (see Figs. 3B and 3C). In another example, the remnant metal 120 present in the structure 100 may be at least 1 ppm, or at least 10 ppm, or at least 100 ppm, or at least 100 parts per billion (ppb), e.g., depending on the extent of the removal and cleaning process of the metal subsequent to formation of the recess 110. In an example, the remnant metal 120 present in the structure 100 may be in the range of 1 - 100 ppm, or 1-1000 ppm, or 20-50 ppm, or another appropriate range, e.g., depending on the extent of the removal and cleaning process of the metal subsequent to formation of the recess 110.

As illustrated in Fig. 1B, the recess 110 (e.g., within which the feature 106 is formed) has a width of wT and a height of hT. In an example, the width wT is measured in a direction that is perpendicular to a length of the feature 106, and the height hT is measured in a direction that is parallel to the length of the feature 106.

Metal assisted etch process is employed to form the recess 110, and metal assisted etch processes can be used to form high aspect ratio trenches and recesses. Thus, in an example, an aspect ratio (e.g., a ratio of the height hT and the width wT) can be as high as 100:1. In an example, the aspect ratio may be at least 5:1, or at least 8:1. In an example, the aspect ratio may be in the range of 8:1 and 20:1. In another example, the aspect ratio may be in the range of 9:1 and 15:1. Other aspect ratios may also be possible.

In an example, the width wT may be in the sub-micron level (e.g., at least 0.1 micron, or at least 0.5 micron), or may be least 1 micron, or at least 5 microns. In an example, the width wT may be in the range of 0.1 micron to 1 micron, 0.1 micron to 5 microns, 1 micron to 10 microns, 5 microns to 10 microns, or 5 microns to 20 microns.

The conductive material 108 has a diameter wc measured in a direction that is perpendicular to a length of the feature 106, as illustrated in Fig. 1B. The diameter wc is correlated with the width wT of the feature 106 (e.g., diameter wc = wT - (2 x (wb+wd))). In an example, the diameter wd may be in the sub-micron level (e.g., at least 0.05 micron, or at least 0.3 micron), or may be least 1 micron, or at least 5 microns. In an example, the diameter wc may be in the range of 0.1 micron to 1 micron, 0.1 micron to 5 microns, 1 micron to 10 microns, 5 microns to 10 microns, or 5 microns to 20 microns.

In an example, the height hT may be in the range of 0.5 micron to 1 micron, 1 micron to 10 microns, 10 microns to 50 microns, 10 microns to 100 microns, or 50 microns to 100 microns. Other ranges may also be possible. The conductive material 108 has the same height hT, as illustrated in Fig. 1B.

Fig. 1A illustrates a distance d between two adjacent recesses 110 of corresponding two adjacent conductive features 106. In an example, the distance d can be in sub-micron or micron level, such as at most 0.5 micron, at most 1 micron, at most 2 microns, at most 5 microns, at most 10 microns, at most 50 microns, or at most 100 microns, or at most 200 microns, or at most 500 microns. In an example, the distance d is based on an ability to define masks 307 (see Fig. 3A) that have adjacent mask sections apart by the distance d. Thus, if the mask 307 may be patterned with a distance of, say, 1 micron between two adjacent mask sections, then the same distance d of 1 micron can be achieved between two adjacent recesses 110.

Referring to Fig. 3A, note that a height hM of the mask 307 used for the metal assisted etching process is relatively less than a height of masks typically used for a reactive ion etch (RIE) process. For example, in the RIE process, while the layer within which the recess is to be formed is etched, the mask is also partially etched (although a rate at which the mask is etched is smaller than a rate at which the layer is being etched). This results in gradual reduction in a height of the mask. Accordingly, in the RIE process, the starting height of the mask has to be large enough, so that even though the mask is gradually etched during the recess formation process, the mask is not fully etched by the end of the RIE process. In contrast, the mask 307 in Fig. 3A is not substantially etched during the metal assisted etching process. Accordingly, the height hM of the mask 307 used for the metal assisted etching process can be made relatively less than a height of a mask typically used for the RIE process. Furthermore, as the height hM is relatively small, the distance d between two adjacent mask sections can be made smaller. Accordingly, recesses formed using metal assisted etching process can be made at a finer pitch than recesses formed using the RIE process.

Fig. 1D illustrates an example system 190 in which the interposer structure 100 of Figs. 1A-1C may be used, in accordance with an embodiment of the present disclosure. The system 190 of Fig. 1D comprises IC chips 180a and 180b. In an example, the IC chips 180a and/or 180b may be chiplets. A chiplet is a relatively smaller chip designed to work with one or more other chiplets, to form a larger and more complex integrated circuit. Multiple chiplets working together in a single integrated circuit are known as multi-chip modules. Although merely two chiplets 180a, 180b are illustrated in Fig. 1D, the system 190 may include more than two such chiplets. The system 190 is an example of a 3D SoC structure. The chiplets 180a, 180b are coupled to the interposer structure 100 through respective solder bumps 182. The interposer structure 100 facilitates communication between the chiplets 180a, 180b through lateral interconnect features 184. In an example, the interposer structure 100 also comprises solder bumps 186 (not illustrated in Figs. 1A and 1B) on a bottom surface of the interposer structure 100. The vertical conductive features 106 couple individual chiplets 180a, 180b to the solder bumps 186 on the bottom surface of the interposer structure 100. The solder bumps 186 are used to couple the system 190 to an IC package substrate (not illustrated) or to a printed circuit board (PCB).

Note that while Fig. 1D illustrates an example system in which the interposer structure 100 may be used, Fig. 1D is not intended to limit the use of the interposer structure 100 to any specific type of system. For example, the interposer structure 100 comprising the features 106 may be used in any appropriate system that uses an interposer structure with vertical conductive features extending from one surface of the interposer structure to an opposite surface of the interposer structure.

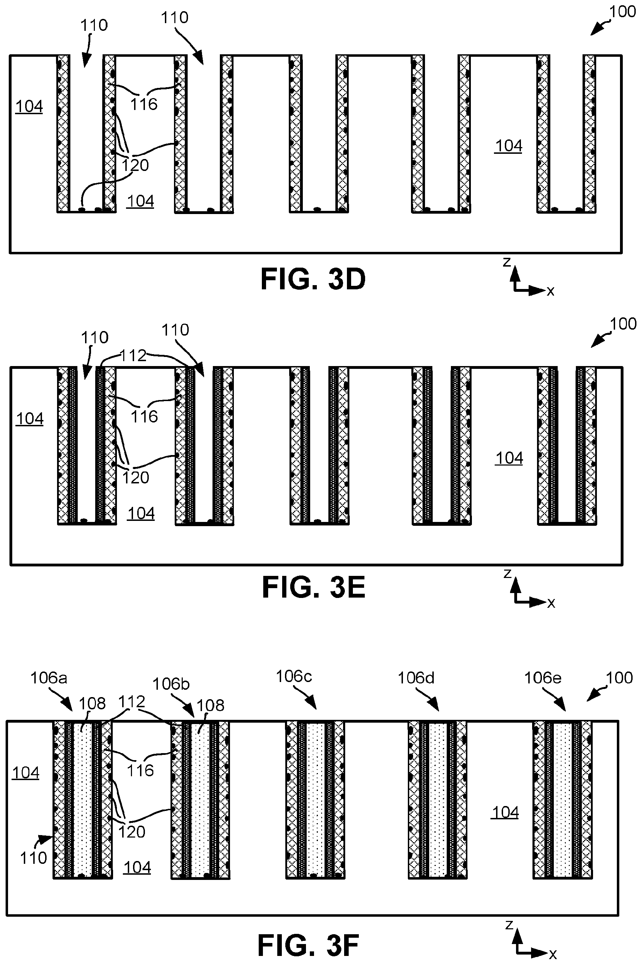

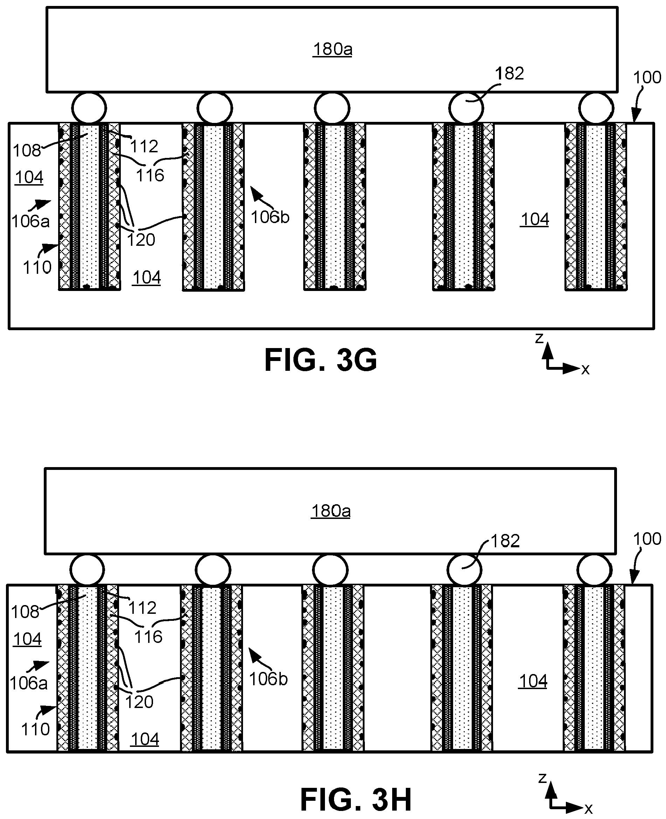

Fig. 2 illustrates a flowchart depicting a method 200 of forming an interposer structure (such as the interposer structure 100 of Figs. 1A-1D) including (i) a layer 104 comprising semiconductor material such as silicon, and (ii) a plurality of conductive features 106 extending through the semiconductor material of the layer 104, wherein a via or recess 110 for a conductive feature 106 is formed using metal assisted etch, and trace amount of the metal 120 (e.g., one or more discontinuous monolayers of the metal) used for the metal assisted etch process is present between the conductive feature 106 and the semiconductor material of the layer 104, in accordance with an embodiment of the present disclosure. Figs. 3A, 3B, 3C, 3D, 3E, 3F, 3G, 3H, and 31 illustrate cross-sectional views of at least a section of an interposer structure of Figs. 1A-2 in various stages of processing, in accordance with an embodiment of the present disclosure. Figs. 2 and 3A-3I will be discussed in unison.

Referring to Fig. 2, the method 200 comprises depositing metal 320 on a plurality of sections of a top surface of a layer 104 (e.g., comprising semiconductor material such as silicon), on which the conductive features 106 are to be formed, and masking remaining sections of the top surface the layer 104. For example, Fig. 3A illustrates the layer 104 comprising semiconductor material such as silicon. Metal 320 are deposited on a plurality of sections of a top surface of the layer 104, on which the conductive features 106 are to be formed. Remaining sections of the top surface of the layer 104 are masked by resist or hard masks 307. Fig. 3A illustrates a height hM of the masks 307 and a distance d between adjacent mask sections, which have been discussed herein previously with respect to Figs. 1A and 1B.

Referring again to Fig. 2, the method 200 then proceeds from 204 to 208, where metal assisted etch is performed using the metal 320 as catalyst, to form a plurality of recesses 110 within the layer 104. In an example, remnants 120 of the metal 320 remain on sidewalls of the recesses 110. Thus, the remnants metal 120 are part of the metal 320 that remain on the sidewalls of the recesses 110, as illustrated in Fig. 3B.

Metal assisted etch, also known as metal induced etch (MIE) or metal assisted chemical etching (MACE), is the process of wet chemical etching of semiconductor material (e.g., silicon or other suitable semiconductor material) with the use of a metal catalyst, usually deposited on the surface of the semiconductor material in the form of a thin film or nanoparticles. The semiconductor material of the layer 104, with the metal 320 deposited thereon, is then immersed in an etching solution containing an appropriate oxidizing agent and hydrofluoric acid. The metal 320 on the surface catalyzes the reduction of the oxidizing agent and therefore, in turn, facilitates dissolution of the semiconductor material of the layer 104. This leads to formation of straight recesses or pores that are etched into the semiconductor material of the layer 104. Thus, a pre-defined pattern of the metal 320 on the surface of the layer 104 can be directly transferred to the layer 104 in the form of recesses 110.

In an example, noble metals such as gold, silver, platinum, and/or palladium, and/or base metals such as iron, nickel, copper, and/or aluminum can act as the metal catalyst 320 in the process. In an example, the etching solution may include an oxidizing agent and hydrofluoric acid.

Referring again to Fig. 2, the method 200 then proceeds from 208 to 212, where the metal 320 is removed from the recesses 110 and the recesses 110 are cleaned, leaving behind one or more discontinuous monolayers of remnant metal 120 on the sidewalls (and possibly also on bottom surfaces) of the recesses 110. For example, Fig. 3C illustrates the recesses 110, with remnant metals 120 on sidewalls (and possibly also on bottom surfaces) of the recesses 110. In an example, the metal 320 are removed and cleaned using an appropriate etching process, such as an isotropic wet etch process.

Referring again to Fig. 2, the method 200 then proceeds from 212 to 216, where dielectric material 116 is conformally deposited on sidewalls of the recesses 110, followed by conformal deposition of barrier layer 112 on the dielectric material 116. In an example, the dielectric material 116 and/or the barrier layer 112 may be deposited using any appropriate deposition technique, such as chemical vapor deposition (CVD), physical vapor deposition (PVD), atomic layer deposition (ALD), vapor-phase epitaxy (VPE), molecular beam epitaxy (MBE), or liquid-phase epitaxy (LPE), for example.

Fig. 3D illustrates deposition of dielectric material 116 on sidewalls of the recesses 110. As discussed, one or more monolayers of the metal 120 may be present on sidewalls (and possibly also on bottom surfaces) of the recess 110. The monolayers of the metal 120 may be discontinuous, such that the monolayers are between some sections of the dielectric material 116 and the semiconductor material of the layer 104, and not between other sections of the dielectric material 116 and the semiconductor material of the layer 104. The dielectric material layer 116, in an example, prevents or reduces electrical interaction between the conductive material 108 and the semiconductor material of the layer 104.

Fig. 3E illustrates the conformal barrier layer 112 on the dielectric material 116. As discussed, the barrier layer 112, in an example, prevents diffusion of the conductive material 108 (such as copper, to be deposited later in the process) to the dielectric material 116 adjacent to the conductive material 108. Furthermore, the barrier layer 112 facilitates better adhesion of the conductive material 108 on walls of the dielectric layer 116.

Referring again to Fig. 2, the method 200 then proceeds from 216 to 220, where conductive material is deposited within the recesses 110, to form a plurality of conductive features 106 within corresponding ones of the plurality of recesses 110. Fig. 3F illustrates the conductive material 108 deposited within the recesses 110. In an example, after deposition of the conductive material 108, the conductive material on the top surface of the structure 100 may be planarized, such that the conductive material 108 within the recesses 110 are coplanar with a top surface of the layer 104.

In an example, deposition of the conductive material 108 includes forming a seed layer (not illustrated in the figures) of conductive material on the barrier layer 112. The seed layer may be formed by a deposition process such as atomic layer epitaxy, CVD, PVD, ALD, VPE, MBE, LPE, via electroplating, e.g., in order to improve subsequent deposition of conductive material. In an example, one or more monolayers of seed material may be used. In an example, the seed layer may be deposited using an electroless deposition. In an example, the seed material is to be subsequently used for an electroplating deposition. In an example, the seed layer comprises copper (Cu) or an alloy of copper (e.g., copper-tin (CuSn), copper-indium (CuIn), copper-magnesium (CuMg), copper-aluminum (CuAl)), cobalt, and/or the like, e.g., to assist with a subsequent formation of a copper containing conductive material thereon. In an example, the process of seed layer formation may be performed if the final conductive material to be deposited in the recesses include copper or another appropriate metal or metal alloy that is to be electroplated. For example, if the final conductive material include copper, then the copper is to be deposited using an electroplating process on the seed layer. The seed layer is used to facilitate the electroplating process.

However, if the final conductive material in the recesses can be deposited using another deposition technique different from electroplating (such as CVD or PVD or ALD), then the process of forming the seed layer can be skipped in an example. In an example, ruthenium may be used as the conductive material and may be deposited using ALD, and hence, deposition of ruthenium may not necessitate the formation of the seed layer.

Subsequent to formation of the seed layer, the conductive material comprising metal (such as copper) may be deposited via electroplating. In another example, electroless deposition, CVD, PVD, ALD or another suitable deposition technique may be used, e.g., when the conductive material comprises ruthenium or another appropriate conductive material.

After deposition of the conductive material, the conductive material is planarized from the top surface of the recesses 310, e.g., using CMP (chemical mechanical polishing), mechanical polishing, or another suitable planarization technique.

Referring again to Fig. 2, the method 200 proceeds from 220 to 224, where an IC chip 108a is attached to a top surface of the resultant interposer structure 100. For example, IC chip 108a is attached to the interposer structure 100 using solder bumps 182. As discussed with respect to Fig. 1D, the IC chip 108a may be a chiplet in an example. Although the top surface of the interposer structure 100 may be coupled to multiple such IC chips (see Fig. 1D), merely one IC chip 108 is illustrated in Fig. 3G. In an example, a solder bump 182 couples a corresponding conductive material 108 of a corresponding conductive feature 106 to the IC chip 108a.

Referring again to Fig. 2, the method 200 proceeds from 224 to 228, where a bottom section of the interposer structure 100 is thinned, e.g., until bottom surfaces of the conductive features 106 are exposed through the bottom surface of the interposer structure 100, as illustrated in Fig. 3H. The thinning process may be performed using an appropriate etching and/or planarization technique. As illustrated in Fig. 3H, the conductive material 108 of the conductive features 106 are now exposed through the bottom surface of the interposer structure 100.

Note that the thinning process can etch off a bottom-most portion of the conductive features 106. As a result, the remnant metals 120 on the bottom surface of the features 106 (which are illustrated in Fig. 3G) may be etched off and hence, are not illustrated in the bottom surfaces of the features 106 in Fig. 3H. In another example and although not illustrated in Figs. 1A, 1B, and 3H, the remnant metals 120 may be present on the bottom surfaces of the features 106, even after the tinning process 228.

Referring again to Fig. 2, the method 200 proceeds from 228 to 232, where solder bumps 186 are attached to bottom surfaces of the conductive features 106. In an example, the solder bumps may be used to attach the bottom surface of the interposer structure 100 to another component, such as a package substrate or a PCB, as discussed with respect to Fig. 1D. In an example, a solder bump 186 is coupled to a corresponding conductive material 108 of a corresponding conductive feature 106, as illustrated in Fig. 31.

Note that the processes in method 200 are shown in a particular order for ease of description. However, one or more of the processes may be performed in a different order or may not be performed at all (and thus be optional), in accordance with some embodiments. Numerous variations on method 200 and the techniques described herein will be apparent in light of this disclosure.

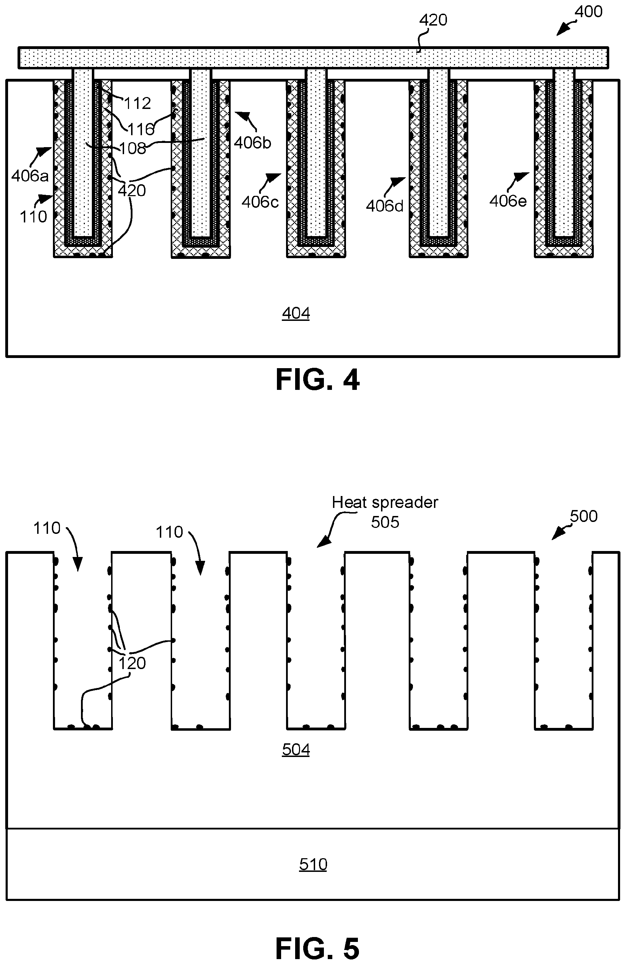

Fig. 4 illustrates a cross-sectional view of a capacitor structure 400 including (i) a layer 404 comprising doped semiconductor material such as doped silicon, and (ii) a plurality of conductive features 406 extending within the doped semiconductor material of the layer 404, and trace amount of metal 420 (e.g., one or more discontinuous monolayers of the metal) between each of the conductive features 406 and the doped semiconductor material of the layer 404, in accordance with an embodiment of the present disclosure.

The conductive features 406 and the trace amount of the metal 420 are at least in part similar to the conductive features 106 and the trace amount of the metal 120 discussed with respect to Figs. 1A-3I. However, in Figs. 1A-1B, the conductive features 106 extended through the layer 104, and both ends of the conductive features 106 were exposed through respective surfaces of the layer 104. In contrast, while a top end of the conductive features 406 are exposed through a top surface of the layer 404, a bottom end of the conductive features 406 are buried within the layer 404, as illustrated in Fig. 4.

Also note the remnant metal 420 on bottom surfaces of the conductive features 406 in Fig. 4, whereas the remnant metal 120 may or may not be present on bottom surfaces of the conductive features 106 in the interposer structure 100 of Figs. 1A or 1B (see discussion with respect to Figs. 3G and 3H).

A conductive line 420 is coupled to top ends of each of the plurality of conductive features 406. In an example, the conductive line 420 forms a first terminal of the capacitor. A second terminal (not illustrated in Fig. 4) may be buried within the doped silicon of the layer 404. The conductive features 406 and the doped silicon, in combination, form a metal-insulator-silicon capacitor (MIS), in an example.

Fig. 5 illustrates a cross-sectional view of an integrated circuit structure 500 including a heat spreader 505 that comprises (i) a plurality of recesses 110 formed using a metal assisted etch process, such that trace amount of metal 120 (e.g., one or more discontinuous monolayers of the metal) are on walls and bottom surfaces of the recesses 110, and (ii) fluid within the recesses 110 to dissipate heat from the IC structure 500, in accordance with an embodiment of the present disclosure.

In one embodiment, the IC structure 500 comprises one or more active devices, one or more passive devices, and one or more interconnect structures, symbolically illustrated as structure 510. The IC structure 500 may be coupled to an external component (such as an interposer or a printed circuit board) using solder bumps (not illustrated) attached to a bottom surface of the IC structure 500. A top section of the IC structure 500 comprises a layer 504 comprising semiconductor material, such as silicon. A plurality of recesses 110 are formed within the layer 504, where top ends of the recesses 110 are exposed through a top surface of the layer 504. The recesses 110 are formed using the techniques discussed with respect to Figs. 2 and 3A-3C. Also illustrated are the traces amount of metal 120 on sidewalls and bottom surfaces of the recesses 110, as discussed with respect to Figs. 3A-3C.

In one embodiment, the recesses 110 are filled with a cooling fluid, such as an immersion liquid used to cool the IC structure 500. The trace amount of metal 120 are one or more discontinuous monolayers of metal, such that the one or more monolayers are between some sections of the fluid and the walls of the recesses 110, and not between other sections of the fluid and the walls of the recesses 110. In an example, the layer 504 including the plurality of recesses 110, along with the fluid, dissipate heat generated by the plurality of devices of the structure 510.

### Example System

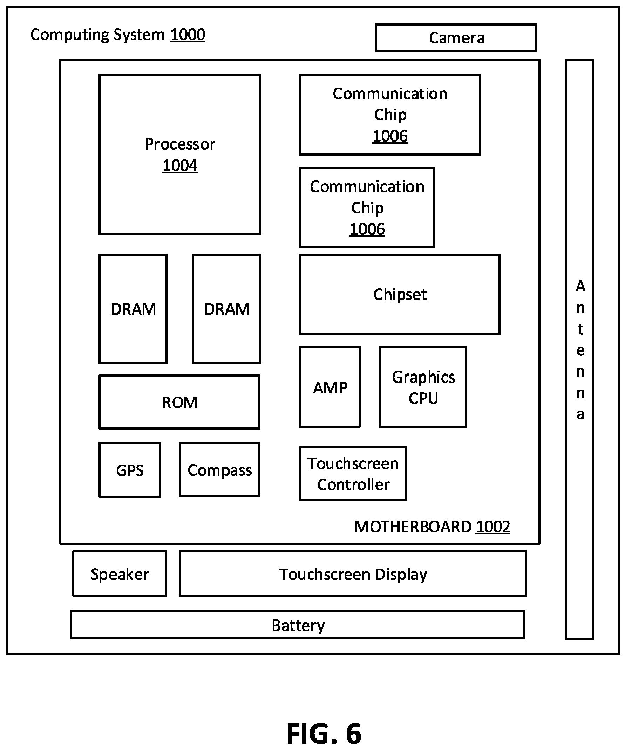

Fig. 6 illustrates a computing system 1000 having conductive features and/or recesses formed using the techniques disclosed herein, in accordance with some embodiments of the present disclosure. As can be seen, the computing system 1000 houses a motherboard 1002. The motherboard 1002 may include a number of components, including, but not limited to, a processor 1004 and at least one communication chip 1006, each of which can be physically and electrically coupled to the motherboard 1002, or otherwise integrated therein. As will be appreciated, the motherboard 1002 may be, for example, any printed circuit board, whether a main board, a daughterboard mounted on a main board, or the only board of system 1000, etc.

Depending on its applications, computing system 1000 may include one or more other components that may or may not be physically and electrically coupled to the motherboard 1002. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1000 may include one or more integrated circuit structures or devices formed using the disclosed techniques in accordance with an example embodiment. In some embodiments, multiple functions can be integrated into one or more chips (e.g., for instance, note that the communication chip 1006 can be part of or otherwise integrated into the processor 1004).

The communication chip 1006 enables wireless communications for the transfer of data to and from the computing system 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing system 1000 includes an integrated circuit die packaged within the processor 1004. In some embodiments, the integrated circuit die of the processor includes onboard circuitry that is implemented with one or more integrated circuit structures or devices formed using the disclosed techniques, as variously described herein. The term "processor" may refer to any device or portion of a device that processes, for instance, electronic data from registers and/or memory to transform that electronic data into other electronic data that may be stored in registers and/or memory.

The communication chip 1006 also may include an integrated circuit die packaged within the communication chip 1006. In accordance with some such example embodiments, the integrated circuit die of the communication chip includes one or more integrated circuit structures or devices formed using the disclosed techniques as variously described herein. As will be appreciated in light of this disclosure, note that multi-standard wireless capability may be integrated directly into the processor 1004 (e.g., where functionality of any chips 1006 is integrated into processor 1004, rather than having separate communication chips). Further note that processor 1004 may be a chip set having such wireless capability. In short, any number of processor 1004 and/or communication chips 1006 can be used. Likewise, any one chip or chip set can have multiple functions integrated therein.

In various implementations, the computing system 1000 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device or system that processes data or employs one or more integrated circuit structures or devices formed using the disclosed techniques, as variously described herein. Note that reference to a computing system is intended to include computing devices, apparatuses, and other structures configured for computing or processing information.

### Further Example Embodiments

The following clauses pertain to further embodiments, from which numerous permutations and configurations will be apparent.

Example 1. An apparatus comprising: a first layer comprising silicon; a conductive feature extending within the silicon of the first layer, the conductive feature comprising (i) conductive material extending throughout the length of the conductive feature, (ii) a barrier layer between the conductive material and the silicon of the first layer, and (iii) a second layer comprising dielectric material between the barrier layer and the silicon of the first layer; and one or more monolayers of metal between sections of the dielectric material and the silicon of the first layer.

Example 2. The apparatus of example 1, wherein the one or more monolayers of metal are discontinuous, such that the one or more monolayers are between some sections of the dielectric material and the silicon of the first layer, and not between other sections of the dielectric material and the silicon of the first layer.

Example 3. The apparatus of any of examples 1-2, wherein the one or more monolayers of metal comprise between 1 part per million (ppm) and 1000 ppm of the metal.

Example 4. The apparatus of any of examples 1-3, wherein the one or more monolayers of metal comprise at most 1000 part per million (ppm) of the metal.

Example 5. The apparatus of any of examples 1-2, wherein the one or more monolayers of metal comprise at least 100 part per billion (ppb) of the metal.

Example 6. The apparatus of any of examples 1-5, wherein the metal comprises one or more of gold, silver, platinum, palladium, or nickel.

Example 7. The apparatus of any of examples 1-6, wherein the metal is a first metal, and wherein the barrier layer comprises a second metal different from the first metal.

Example 8. The apparatus of any of examples 1-7, wherein the metal is a first metal, wherein the barrier layer comprises a second metal different from the first metal, and wherein the conductive material comprises a third metal different from each of the first and second metals.

Example 9. The apparatus of any of examples 1-8, wherein the barrier layer comprises one or more of cobalt, nickel, ruthenium, molybdenum, manganese, titanium, tungsten, tantalum, nitrogen, or silicon.

Example 10. The apparatus of any of examples 1-9, wherein the conductive material comprises copper.

Example 11. The apparatus of any of examples 1-10, wherein the conductive material comprises one or more of copper, ruthenium, molybdenum, tungsten, tin, indium, antimony, aluminum, or bismuth.

Example 12. The apparatus of any of examples 1-11, wherein the conductive feature has a height-to-width aspect ratio of at least 8:1.

Example 13. The apparatus of any of examples 1-12, wherein the conductive feature has a height-to-width aspect ratio in the range of 8:1 to 20:1.

Example 14. The apparatus of any of examples 1-13, wherein the apparatus is an interposer structure.

Example 15. The apparatus of any of examples 1-14, wherein the conductive feature is a through-silicon via extending from a first surface of the first layer to a second surface of the first layer.

Example 16. The apparatus of any of examples 1-15, wherein a first end of the conductive material is coupled to an interconnect feature of an integrated circuit (IC) chip, and wherein a second end of the conductive material is coupled to another interconnect feature coupling the apparatus to a printed circuit board.

Example 17. The apparatus of any of examples 1-16, wherein: a first end of the conductive material is coupled to a first bump comprising another conductive material, the first bump to couple the apparatus to an integrated circuit (IC) chip; and a second end of the conductive material is coupled to a second bump comprising another conductive material, the second bump to couple the apparatus to a printed circuit board.

Example 18. The apparatus of any of examples 1-17, wherein the conductive feature is a first conductive feature, and wherein the apparatus comprises: a plurality of conductive features, including the first conductive feature, extending within the silicon of the first layer.

Example 19. The apparatus of example 18, further comprising: a conductive line external to the layer, wherein a first end of each of the plurality of conductive features is coupled to the conductive line.

Example 20. The apparatus of example 19, wherein: the first layer has a first surface and an opposite second surface; the first end of each of the plurality of conductive features is exposed through the first surface of the first layer, wherein each of the plurality of conductive features has a second end opposite the first end; and each of the plurality of conductive features extend partially, and not fully, through the first layer, such that the second end of each of the plurality of conductive features is not exposed through the second surface of the first layer.

Example 21. The apparatus of any of examples 19-20, wherein the silicon of the layer is doped, and the plurality of conductive features and the doped silicon, in combination, comprise a metal-insulator-silicon (MIS) capacitor.

Example 22. The apparatus of any of examples 1-21, wherein the conductive feature is formed within a recess extending through the silicon of the first layer, and the one or more monolayers of metal are on sidewalls of the recess.

Example 23. The apparatus of example 22, wherein the one or more monolayers of metal are remnants of metal used to etch the recess within the silicon of the layer using a metal assisted etch process.

Example 24. An integrated circuit including the apparatus of any of examples 1-23.

Example 25. A microelectronics device comprising: a layer comprising semiconductor material; a recess extending within the semiconductor material of the layer; trace amount of a metal, with a concentration of at most 1000 parts per million (ppm), on walls of the recess; a dielectric material at least in part on walls of the recess, such that the trace amount of metal is between some sections of the dielectric material and the walls of the recess, and not between other sections of the dielectric material and the walls of the recess; and conductive material within the recess.

Example 26. The microelectronics device of example 25, further comprising: a barrier layer between the conductive material and the dielectric material.

Example 27. The microelectronics device of any of examples 25-26, wherein the conductive material extends throughout the length of the recess.

Example 28. The microelectronics device of any of examples 25-27, wherein the trace amount of metal has the concentration of at most 500 ppm.

Example 29. The microelectronics device of any of examples 25-28, wherein the trace amount of metal has the concentration of at most 100 ppm.

Example 30. The microelectronics device of any of examples 25-29, wherein the trace amount of metal has the concentration of at most 1 ppm.

Example 31. The microelectronics device of any of examples 25-29, wherein the trace amount of metal has the concentration of at least 1 ppm.

Example 32. The microelectronics device of any of examples 25-29, wherein the trace amount of metal has the concentration of at least 10 ppm.

Example 33. The microelectronics device of any of examples 25-29, wherein the trace amount of metal has the concentration of at least 100 parts per billion (ppb).

Example 34. The microelectronics device of any of examples 25-33, wherein the semiconductor material comprises silicon.

Example 35. The microelectronics device of any of examples 25-34, wherein the metal comprises one or more of gold, silver, platinum, palladium, or nickel.

Example 36. The microelectronics device of any of examples 25-35, wherein the dielectric material and the conductive material form a through-hole via extending from a first surface of the layer to a second surface of the layer.

Example 37. The microelectronics device of any of examples 25-36, wherein the semiconductor material comprises silicon, and wherein the dielectric material and the conductive material form a through-silicon via extending from a first surface of the layer to a second surface of the layer.

Example 38. The microelectronics device of any of examples 25-37, wherein the conductive material comprises copper.

Example 39. The microelectronics device of any of examples 25-37, wherein the conductive material comprises one or more of copper, ruthenium, molybdenum, tungsten, tin, indium, antimony, aluminum, or bismuth.

Example 40. The microelectronics device of any of examples 25-39, the metal is a first metal, and wherein the conductive material comprises a second metal different from the first metal.

Example 41. The microelectronics device of any of examples 25-40, wherein the recess has a height-to-width aspect ratio of at least 8:1.

Example 42. The microelectronics device of any of examples 25-41, wherein the recess has a height-to-width aspect ratio in the range of 8:1 to 20:1.

Example 43. The microelectronics device of any of examples 25-42, wherein a first end of the conductive material is coupled to an interconnect feature of an integrated circuit (IC) chip, and wherein a second end of the conductive material is coupled to another interconnect feature coupling the apparatus to a printed circuit board.

Example 44. The microelectronics device of any of examples 25-43, wherein: a first end of the conductive material is coupled to a first bump comprising another conductive material, the first bump to couple the apparatus to an integrated circuit (IC) chip; and a second end of the conductive material is coupled to a second bump comprising another conductive material, the second bump to couple the apparatus to a printed circuit board.

Example 45. The microelectronics device of any of examples 25-44, wherein the recess is a first recess, and wherein the apparatus comprises: plurality of recesses, including the first recess, extending within the semiconductor material of the layer; trace amount of the metal on walls of each of the plurality of recess; the dielectric material at least in part on walls of each of the plurality of recesses; and the conductive material within each of the plurality of recesses.

Example 46. The microelectronics device of example 45, further comprising: a conductive line external to the layer, wherein a first end of conductive material within each of the plurality of recesses is coupled to the conductive line.

Example 47. The microelectronics device of example 46, wherein: the layer has a first surface and an opposite second surface; the first end of the conductive material of each of the plurality of recesses is exposed through the first surface of the layer, wherein the conductive material within each of the plurality of recesses has a second end opposite the first end; and the conductive material within each of the plurality of recesses extend partially, and not fully, through the layer, such that the second end of the conductive material of each of the plurality of recesses is not exposed through the second surface of the layer.

Example 48. The microelectronics device of any of examples 46-47, wherein the semiconductor material of the layer comprises doped silicon, and the conductive material and dielectric material within each of the plurality of recesses and the doped silicon, in combination, comprise a metal-insulator-silicon (MIS) capacitor.

Example 49. The microelectronics device of any of examples 25-48, wherein the trace amount of metal are remnants of metal used to etch the recess within the layer using a metal assisted etch process,

Example 50. An integrated circuit including the microelectronics device of any of examples 25-49.

Example 51. An integrated circuit device comprising: a layer comprising semiconductor material; a plurality of active devices below the layer comprising the semiconductor material; a plurality of recesses extending within the semiconductor material of the layer, wherein a top end of each of the plurality of recesses is exposed through a top surface of the layer; one or more monolayers of metal on walls of each recess of the plurality of recesses; and a fluid within one or more recesses of the plurality of recesses.

Example 52. The integrated circuit device of example 51, wherein the semiconductor material comprises silicon.

Example 53. The integrated circuit device of any of examples 51-52, wherein the top section of the layer including the plurality of recesses, along with the fluid, form a heat spreader.

Example 54. The integrated circuit device of any of examples 51-53, wherein the top section of the layer including the plurality of recesses, along with the fluid, dissipate heat generated by the plurality of active devices.

Example 55. The integrated circuit device of any of examples 51-54, wherein the one or more monolayers of metal on walls of a first recess are discontinuous monolayers of metal, such that the one or more monolayers are between some sections of the fluid and the walls of the first recess, and not between other sections of the fluid and the walls of the first recess.

Example 56. The integrated circuit device of any of examples 51-55, wherein the one or more monolayers of metal on walls of a first recess are remnants of metal used to etch the first recess within the semiconductor material of the layer.

Example 57. A method of forming a conductive feature within a layer comprising semiconductor material, the method comprising: depositing (i) a metal on a first section of a top surface of the layer, and (ii) one or more masks on one or more second sections of the top surface of the layer; etching a portion of the layer underneath the first section using a metal assisted etch process, to define a recess within the layer, where the metal acts as a catalyst in the etching process; removing the metal from the recess, where remnants of the metal remain on sidewalls of the recess; depositing dielectric material at least in part on sidewalls of the recess, such that the remnants of the metal are between some sections of the dielectric material and the sidewalls of the recess, and not between other sections of the dielectric material and the sidewalls of the recess; and depositing conductive material within the recess.

Example 58. The method of example 57, wherein the dielectric material separates the conductive material from the semiconductor material of the layer.

Example 59. The method of any of examples 57-58, further comprising: prior to depositing the conductive material, depositing a barrier layer on the dielectric material, wherein the dielectric material separates the barrier layer from the semiconductor material of the layer.

Example 60. The method of example 59, wherein the barrier layer separates the conductive material from the dielectric material.

Example 61. The method of any of examples 57-60, wherein the recess is formed on a top portion of the layer, and wherein the method further comprises: thinning a bottom portion of the layer, such that subsequent to the thinning, a bottom surface of the conductive material is exposed through a bottom surface of the layer.

Example 62. The method of example 61, further comprising: attaching a solder material on the exposed bottom surface of the conductive material.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner, and may generally include any set of one or more limitations as variously disclosed or otherwise demonstrated herein.

## Claims

1. An apparatus comprising:
a first layer comprising silicon;
a conductive feature extending within the silicon of the first layer, the conductive feature comprising (i) conductive material extending throughout the length of the conductive feature, (ii) a barrier layer between the conductive material and the silicon of the first layer, and (iii) a second layer comprising dielectric material between the barrier layer and the silicon of the first layer; and
one or more monolayers of metal between sections of the dielectric material and the silicon of the first layer.

2. The apparatus of claim 1, wherein the one or more monolayers of metal are discontinuous, such that the one or more monolayers are between some sections of the dielectric material and the silicon of the first layer, and not between other sections of the dielectric material and the silicon of the first layer.

3. The apparatus of claim 1 or 2, wherein the one or more monolayers of metal comprise between 1 part per million (ppm) and 1000 ppm of the metal.

4. The apparatus of any one of claims 1 through 3, wherein the metal comprises one or more of gold, silver, platinum, palladium, or nickel.

5. The apparatus of any one of claims 1 through 4, wherein the metal is a first metal, wherein the barrier layer comprises a second metal different from the first metal, and wherein the conductive material comprises a third metal different from each of the first and second metals.

6. The apparatus of any one of claims 1 through 5, wherein the conductive material comprises one or more of copper, ruthenium, molybdenum, tungsten, antimony, aluminum, or bismuth.

7. The apparatus of any one of claims 1 through 6, wherein the conductive feature has a height-to-width aspect ratio of at least 8:1.

8. The apparatus of any one of claims 1 through 7, wherein a first end of the conductive material is coupled to an interconnect feature of an integrated circuit chip, and wherein a second end of the conductive material is coupled to another interconnect feature coupling the apparatus to a printed circuit board.

9. The apparatus of any one of claims 1 through 8, wherein:
a first end of the conductive material is coupled to a first bump comprising another conductive material, the first bump to couple the apparatus to an integrated circuit chip; and
a second end of the conductive material is coupled to a second bump comprising another conductive material, the second bump to couple the apparatus to a printed circuit board.

10. The apparatus of any one of claims 1 through 9, wherein the conductive feature is a first conductive feature, and wherein the apparatus comprises:
a plurality of conductive features, including the first conductive feature, extending within the silicon of the first layer.

11. The apparatus of claim 10, further comprising:
a conductive line external to the layer, wherein a first end of each of the plurality of conductive features is coupled to the conductive line.

12. The apparatus of claim 11, wherein:
the first layer has a first surface and an opposite second surface;
the first end of each of the plurality of conductive features is exposed through the first surface of the first layer, wherein each of the plurality of conductive features has a second end opposite the first end; and
each of the plurality of conductive features extend partially, and not fully, through the first layer, such that the second end of each of the plurality of conductive features is not exposed through the second surface of the first layer.

13. The apparatus of claim 11 or 12, wherein the silicon of the layer is doped, and the plurality of conductive features and the doped silicon, in combination, comprise a metal-insulator-silicon (MIS) capacitor.

14. The apparatus of any one of claims 1 through 13, wherein:
the conductive feature is formed within a recess extending through the silicon of the first layer;
the one or more monolayers of metal are on sidewalls of the recess; and
the one or more monolayers of metal are remnants of metal used to etch the recess within the silicon of the layer using a metal assisted etch process.

15. An integrated circuit including the apparatus of any of claims 1 through 14.
